# EUROPÄISCHE PATENTSCHRIFT

(11) **EP 0 855 798 B1**
(45) Veröffentlichungstag und Bekanntmachung des Hinweises auf die Patenterteilung: **07.09.2005**
(21) Anmeldenummer: 98200089.5
(22) Anmeldetag: 14.01.1998
(51) Int. Cl.: H03K 5/08

(54) **Schaltungsanordnung zum Erzeugen eines Ausgangssignals**
Circuit arrangement for generating an output signal
Circuit pour la génération d'un signal de sortie

(30) Priorität: 23.01.1997 DE 19702303
(43) Veröffentlichungstag der Anmeldung: 29.07.1998
(73) Patentinhaber: Philips Intellectual Property & Standards GmbH, 20099 Hamburg (DE); Koninklijke Philips Electronics N.V., 5621 BA Eindhoven (NL)
(72) Erfinder: Mores, Robert, Dr., Röntgenstrasse 24, 22335 Hamburg (DE); Eisele, Harald, Röntgenstrasse 24, 22335 Hamburg (DE)
(74) Vertreter: Peters, Carl Heinrich

(56) Entgegenhaltungen:
- EP-A- 0 455 910
- US-A- 4 585 952
- US-A- 4 639 681
- US-A- 5 418 409

## Beschreibung

Die Erfindung betrifft eine Schaltungsanordnung zum Erzeugen eines Ausgangssignals mit mehreren vorgegebenen Werten, die im wesentlichen übergangslos wechseln, aus einem sich wesentlich langsamer ändernden Eingangssignal.

Derartige Schaltungsanordnungen sind allgemein bekannt, beispielsweise aus dem Buch von Tietze/Schenk "Halbleiter-Schaltungsanordnungen", Springer-Verlag 1978, Seiten 134 und 135 sowie Seiten 412 bis 415 und dienen dazu, aus einem Eingangssignal mit langsamen Signalübergängen insbesondere eindeutige binäre Signale mit zwei Signalwerten zu erzeugen, die in logischen Schaltungen weiterverarbeitet werden können. Bei einer solchen Schaltung wechselt das Ausgangssignal seinen Wert, wenn das Eingangssignal einen hohen Schwellenwert überschreitet, und das Ausgangssignal kehrt wieder auf seinen vorhergehenden Wert zurück, wenn das Eingangssignal danach einen niedrigeren Schwellenwert unterschreitet. Auf diese Weise wird erreicht, daß das Ausgangssignal nicht von eventuellen kleinen Störsignalen, die dem Eingangssignal überlagert sind, beeinflußt wird. Wenn nämlich das Eingangssignal den oberen Schwellenwert überschritten hat, kann nur ein negatives Störsignal, das das Eingangssignal unter den unteren Schwellenwert bringt, eine Änderung des Ausgangssignals erzeugen, und umgekehrt bei der Rückflanke des Eingangssignals.

Nachteilig ist bei den bekannten Schaltungen, daß die Auswertung des Signals erst relativ spät nach Beginn der ansteigenden oder abfallenden Flanke möglich ist. Wenn die Eingangssignale von einem Bus kommen, an dem mehrere Geräte angeschlossen sind, von denen jedes Gerät die Übertragung einer Nachricht auslösen kann (Multimaster-Betrieb), wird zur Vermeidung von Konflikten auf dem Bus jedes Signal eine vorgegebene Zeit nach dem Beginn der Vorderflanke des Signals abgetastet und nur der Signalzustand bei der Abtastung ausgewertet. Bei einem räumlich ausgedehnten Bus können die Signalflanken relativ flach sein, so daß die Dauer jedes Signals einen bestimmten Wert nicht unterschreiten darf. Dadurch wird die maximale Frequenz der Signale und damit Übertragungskapazität auf dem Bus beschränkt. Außerdem ist bei den bekannten Schaltungen erforderlich, daß das Eingangssignal sowohl den höheren Schwellenwert überschreitet als auch den niedrigeren Schwellenwert unterschreitet. Wenn das Eingangssignal jedoch von der Signaldifferenz auf zwei Leitungen, die ein Signal im Gegentakt übertragen, abgeleitet wird und beispielsweise eine dieser beiden Leitungen durch ein Leitungsfehler ständig ein hohes oder ein niedriges Signal überträgt, ändert sich das davon abgeleitete Eingangssignal mit einem kleineren Hub nur im unteren oder nur im oberen Wertebereich, so daß in diesem Falle mittels bekannter Schaltungsanordnungen nur schwierig ein brauchbares Ausgangssignal erhalten werden kann.

Aufgabe der Erfindung ist es, eine Schaltungsanordnung der eingangs genannten Art anzugeben, die eine möglichst schnelle Auswertung einer Eingangssignaländerung ermöglicht und die auch bei Eingangssignalen mit einem geringeren Hub und einem Offset in der Größenordnung dieses geringeren Signalhubs noch weitgehend zuverlässig arbeitet.

Diese Aufgabe wird erfindungsgemäß dadurch gelöst, daß der Schwellenwert, bei dem das Ausgangssignal den Wert wechselt, bei der ansteigenden Flanke des Eingangssignals niedrig und bei der abfallenden Flanke des Eingangssignals hoch ist. Die Umschaltung zwischen diesen beiden Schwellenwerten wird abhängig vom Eingangssignal durchgeführt, und zwar bei weiteren Schwellenwerten, die unterschiedlich zu den erstgenannten Schwellenwerten sein können. Die Umschaltung auf den höheren Schwellenwert erfolgt, wenn die ansteigende Flanke des Eingangssignals mindestens diesen höheren Schwellenwert überschritten hat, und die Rückschaltung auf den niedrigeren Schwellenwert erfolgt, wenn bei der abfallenden Flanke des Eingangssignals wenigstens dieser niedrigere Schwellenwert unterschritten wird. Der Wechsel des Ausgangssignals kann dabei früher erfolgen als bei bekannten Schaltungen, nämlich kurz nach dem Beginn der ansteigenden bzw. der abfallenden Flanke. Eine zwangsläufige Folge dieser Maßnahme ist allerdings, daß der Störabstand zumindest für bestimmte Störsignale verringert wird. Dies wird dadurch kompensiert, daß in bekannter Weise das Eingangsignal eine bestimmte Zeitspanne nach dem ersten Wechsel des Ausgangssignals abgetastet wird.

Das erfindungsgemäße Prinzip läßt sich auch anwenden, wenn das Ausgangssignal nicht binär ist, sondern mehr als zwei Werte annehmen kann. Dafür sind dann entsprechend mehr Schwellenwerte erforderlich. Die Umschaltung der Schaltschwelle vom unteren oder ersten Schwellenwert auf den oberen oder zweiten Schwellenwert kann erfolgen, wenn das Eingangssignal einen dritten Schwellenwert überschritten hat, der größer als oder gleich dem zweiten Schwellenwert sein kann, und entsprechend kann die Umschaltung der Schaltschwelle auf den ersten Schwellenwert erfolgen, wenn das Eingangssignal einen vierten Schwellenwert unterschritten hat, der gleich oder niedriger als der erste Schwellenwert ist. Bei Gleichheit der Schwellenwerte kann eine größere Unempfindlichkeit gegen Strörsignale erreicht werden, wenn die Umschaltung nach Erreichen des entsprechenden Schwellenwertes verzögert erfolgt.

Eine konkrete Ausführung von der erfindungsgemäßen Schaltungsanordnung kann darin bestehen, daß zur Erzeugung des Ausgangssignals ein Vergleicher verwendet wird, der das Eingangssignal mit einem Schwellenwert vergleicht und bei Gleichheit den Wert des Ausgangssignals wechselt, wobei der Schwellenwert durch eine zusätzliche Schalteinrichtung abhängig vom Eingangssignal umgeschaltet wird. Wenn der Vergleicher bei dem jeweiligen Schwellenwert eine Schalthysterese aufweist, wird die Empfindlichkeit gegenüber Störsignalen im Eingangssignal verringert.

Bei einer anderen Ausführungsform der erfindungsgemäßen Schaltungsanordnung werden zwei Vergleicher verwendet, von denen der eine das Eingangsignal mit dem ersten Schwellenwert und der andere mit dem zweiten Schwellenwert vergleicht. Die Ausgänge der beiden Vergleicher führen auf einen Umschalter, der abhängig vom dritten bzw. vierten Schwellenwert umgeschaltet wird und damit das Ausgangssignal von dem Ausgang des einen oder des anderen Vergleichers abnimmt. Dies wirkt in genau gleicher Weise wie die Umschaltung des Schwellenwertes bei Verwendung nur eines Vergleichers für den ersten und zweiten Schwellenwert. Auch in diesem Falle können die beiden Vergleicher oder wenigstens einer davon eine Schalthysterese aufweisen, um die Empfindlichkeit gegenüber Störsignale im Eingangsignal zu verringern.

Die Umschaltung des Schwellenwertes bei Verwendung eines Vergleichers oder des Ausgangssignals bei Verwendung von zwei Vergleichern erfolgt mit Hilfe einer Schalteinrichtung, die vom Eingangssignal gesteuert wird. Diese kann einen Schwellwertschalter mit Hysterese enthalten, wobei die Umschaltpunkte gleich dem dritten bzw. dem vierten Schwellenwert sind. Es kann aber auch für jeden dieser beiden Schwellenwerte ein eigener Vergleicher verwendet werden, und beide Vergleicher steuern eine Speicherstufe, deren Ausgangssignal die Umschaltung bewirkt. Bei der letztgenannten Ausführungsform und der Verwendung von zwei Vergleichern für das Erzeugen des Ausgangssignals können außerdem die Signale an den Ausgängen dieser Vergleicher direkt zur Steuerung der Speicherstufe verwendet werden. Dies ergibt einen besonders einfachen Aufbau.

Ausführungsbeispiele der Erfindung werden nachfolgend anhand der Zeichnung näher erläutert. Es zeigen
Fig. 1 schematisch eine Anordnung zur Auswertung differentieller Signale mit der erfindungsgemäßen Schaltungsanordnung,
Fig. 2 beispielhafte Signalverläufe an Punkten der Schaltungsanordnung nach Fig. 1 im ungestörten Fall und bei Störung einer der beiden Leitungen,
Fig. 3 eine Ausführungsform der erfindungsgemäßen Schaltungsanordnung für mehr als zwei verschiedene Werte des Ausgangssignals,
Fig. 4 beispielhafte Signalverläufe an verschiedenen Punkten der Schaltungsanordnung nach Fig. 3,
Fig. 5 eine andere Ausführung der Schaltanordnung zur Umschaltung der Schwellenwerte,
Fig. 6 eine Schaltungsanordnung, bei der das Ausgangssignal umgeschaltet wird,
Fig. 7 eine Schaltungsanordnung, bei der die Speicherstufe von den Ausgängen der Vergleicher für das Ausgangssignal gesteuert werden,
Fig. 8 beispielhafte Signalverläufe an einzelnen Punkten der Schaltung nach Fig. 7,
Fig. 9 eine Schaltungsanordnung, bei der der Umschalter mit Gattern realisiert ist.

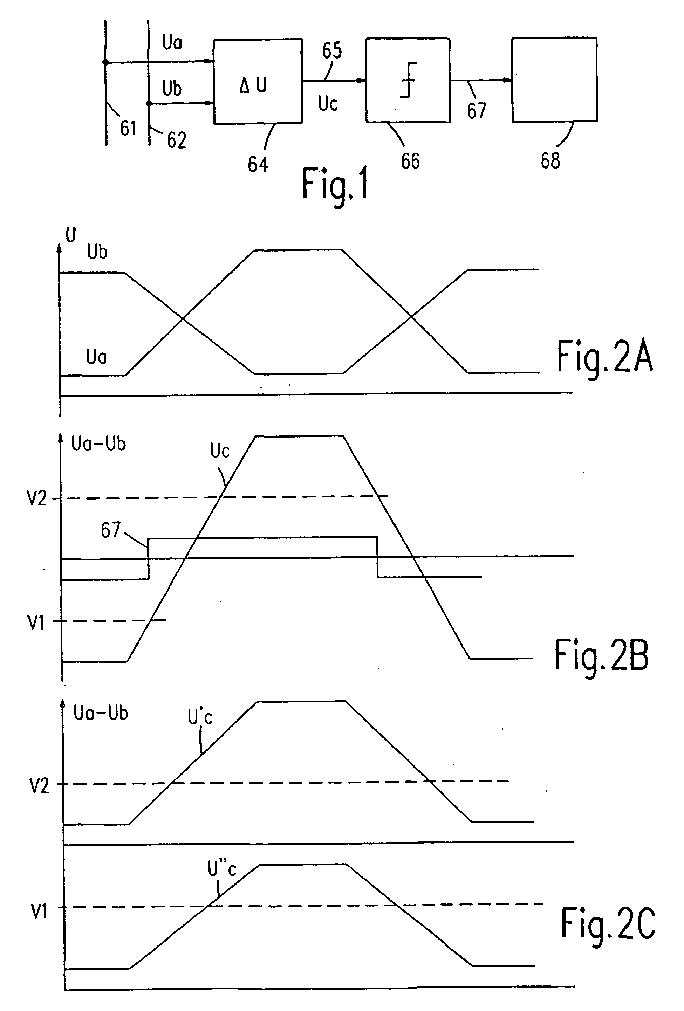

In dem Blockschaltbild der Fig. 1 werden auf zwei Leitungen 61 und 62 Signale im Gegentakt übertragen, wie in Fig. 2a mit den Spannungsverläufen für die Signalspannungen Ua und Ub dargestellt ist. Diese beiden Signalspannungen werden einer Stufe 64 zugeführt, die daraus die Differenz Ua - Ub der beiden Signalspannungen bildet, die als Signalspannung Uc auf der Leitung 65 abgegeben wird. Die Leitung 65 führt auf einen Block 66, der die erfindungsgemäße Schaltungsanordnung enthält und Ausgangssignale mit steilen Flanken auf der Leitung 67 erzeugt. Diese werden einer Verarbeitungsanordnung 68 zugeführt, die hier nicht näher erläutert wird, da sie nicht zur Erfindung gehört.

Der Verlauf der Signalspannung Uc = Ua - Ub und der Spannung auf der Leitung 67 sind in Fig. 2b dargestellt. Die Spannung Uc, die das Eingangssignal für der Block 66 bildet, geht hier von negativen zu positiven Werten, jedoch ist klar, daß durch eine entsprechenden Spannungsverschiebung auch nur positive Werte für die Signalspannung Uc erzeugt werden können.

Die erfindungsgemäße Schaltungsanordnung im Block 66 ist nun so aufgebaut, daß das Signal auf der Leitung 67 seinen Wert bereits wechselt, wenn die Signalspannung Uc einen unteren Schwellenwert V1 überschreitet. Wenn die Signalspannung Uc einen oberen Schwellenwert V2 oder einen noch höheren Schwellenwert überschreitet, wird die Schaltschwelle der Schaltungsanordnung im Block 66 auf den Schwellenwert V2 umgeschaltet, und dadurch wechselt das Signal auf der Leitung 67 seinen Wert bei der abfallenden Flanke der Signalspannung Uc, wenn der zweite Schwellenwert V2 unterschritten wird. In beiden Fällen wird also frühzeitig nach Beginn einer Änderung der Signalspannung Uc ein Ausgangssignal erzeugt, so daß eine schnellere bzw. frühere Auswertung der Signaländerungen auf den Leitungen 61 und 62 möglich ist.

In Fig. 2c ist der Verlauf der Signalspannung Uc für die Fälle dargestellt, daß die Leitung 61 oder die Leitung 62 defekt ist, beispielsweise indem die betreffende Leitung Kurzschluß gegen Masse oder gegen Versorgungsspannung hat. Bei dem Signalverlauf U'c ist angenommen, daß die Spannung Ua ständig auf hohem Potential oder die Spannung Ub ständig auf Bezugspotential liegt. Entsprechend ist für den Verlauf der Signalspannung U"c angenommen, daß die Spannung Ub ständig auf hohem Potential liegt oder die Spannung Ua ständig Bezugspotential hat. Es ist zu erkennen, daß die Spannung U'c niemals den unteren Schwellenwert V1 kreuzt, so daß ständig der obere Schwellenwert V2 wirksam bleibt. Entsprechend durchläuft die Signalspannung U"c niemals den oberen Schwellenwert V2, so daß hierfür ständig der untere Schwellenwert V1 wirksam bleibt. In beiden Fällen wird also mit der erfindungsgemäßen Schaltung ein Ausgangssignal erzeugt.

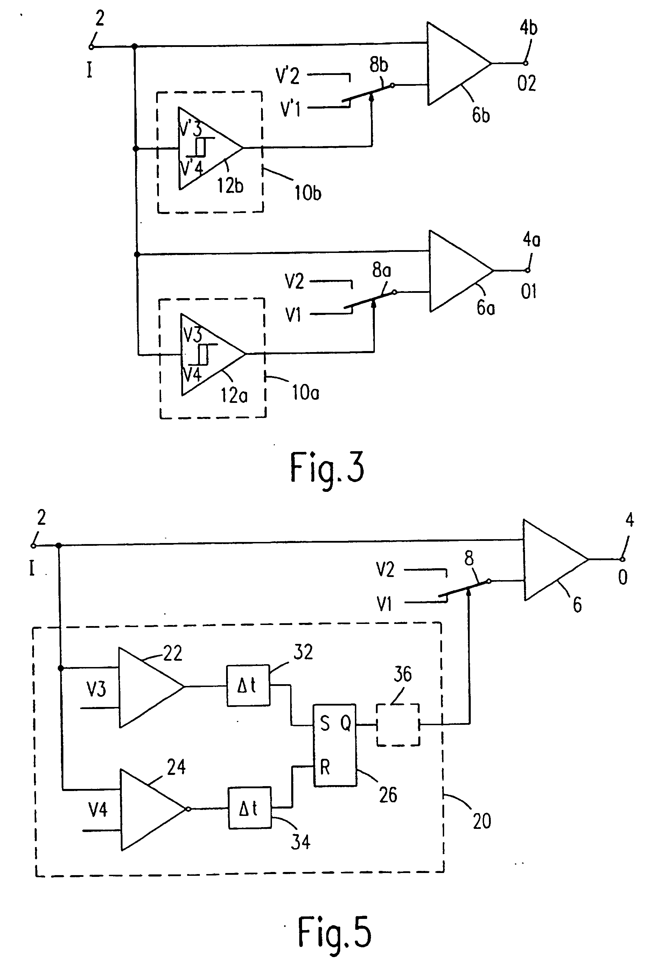

In Fig. 3 ist eine Ausführungsform der Schaltungsanordnung dargestellt, die in Fig. 1 durch den Block 66 angedeutet ist. Diese Schaltungsanordnung dient in diesem Beispiel zur Erzeugung von drei verschiedenen Werten des Ausgangssignals, das an zwei getrennten Ausgängen 4a und 4b für je ein binäres Signal abgegeben wird. Ein Signaleingang 2 für ein Eingangsignal I ist mit einem ersten Eingang von zwei Vergleichern 6a und 6b verbunden, die einen zweiten Eingang aufweisen, der mit einem Umschalter 8a bzw. 8b verbunden ist. Das Ausgangssignal der Vergleicher 6a bzw. 6b, das am Ausgang 4a bzw. 4b abgegeben wird, wechselt den binären Zustand, wenn die Signalspannung am ersten Eingang des betreffenden Vergleichers die Spannung am zweiten Eingang überschreitet bzw. unterschreitet. Dem zweiten Eingang der Vergleicher 6a bzw. 6b wird abhängig von der Stellung des Umschalters 8a bzw. 8b ein ersten Schwellenwert V1 bzw. V'1 oder ein zweiter Schwellenwert V2 bzw. V'2 zugeführt.

Die Stellung der Umschalter 8a und 8b wird durch eine Schalteinrichtung 10a bzw. 10b gesteuert, die einen Eingang aufweist, der ebenfalls mit dem Signaleingang 2 verbunden ist. Die Schalteinrichtung 10a, die den Umschalter 8a steuert, enthält einen Schmitt-Trigger 12a, dessen Ausgangssignal von einem ersten Wert auf einen zweiten Wert wechselt, wenn eine obere Schaltschwelle V3 überschritten wird, und dessen Ausgangssignal den ersten Wert wieder annimmt, wenn danach eine untere Schaltschwelle V4 unterschritten wird. In entsprechender Weise enthält die Schalteinrichtung 10b einen Schmitt-Trigger 12b, dessen Ausgangssignal den Wert wechselt, wenn eine obere Schaltschwelle V'3 überschritten bzw. eine untere Schaltschwelle V'4 unterschritten wird.

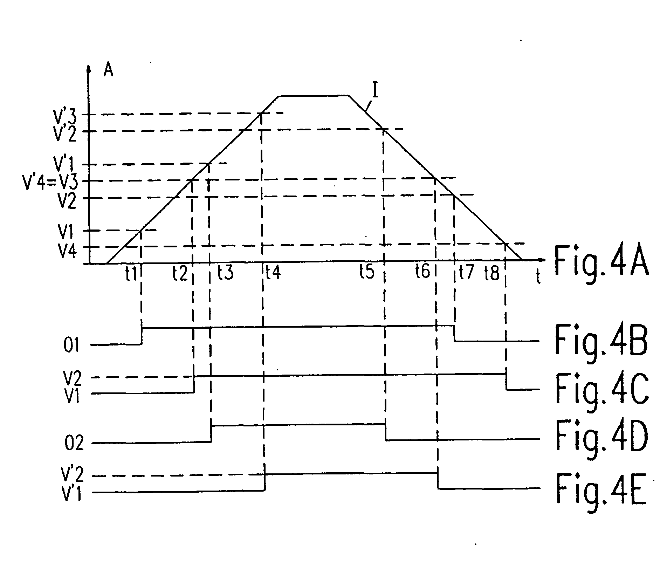

Die Funktion der in Fig. 3 dargestellten Schaltungsanordnung soll anhand des Diagramms in Fig. 4 erläutert werden. In Fig. 4a ist ein Eingangssignal mit einer linear ansteigenden und abfallenden Flanke dargestellt. Diese Flanken durchlaufen verschiedene Schwellenwerte V1 bis V4 bzw. V'1 bis V'4, wobei in diesem Beispiel angenommen ist, daß der Schwellenwert V3 gleich dem Schwellenwert V'4 ist.

Zu Beginn befinden sich die Umschalter 8a und 8b in der in Fig. 3 dargestellten Stellung. Die Vergleicher 6a und 6b geben ein niedriges Signal an den Ausgängen 4a bzw. 4b ab, wenn das Eingangssignal I unter dem Schwellenwert V1 bzw. V'1 liegt. Wenn das Eingangssignal den Schwellenwert V1 zum Zeitpunkt t1 überschreitet, geht das Ausgangssignal O1 am Ausgang 4a auf einen hohen Wert, wie in Fig. 4b dargestellt ist. Wenn das Eingangssignal I den Schwellenwert V2 durchläuft, ändert sich in der Schaltungsanordnung nach Fig. 3k ein Signal. Erst wenn zum Zeitpunkt t2 der Schwellenwert V3 überschritten wird, schaltet die Schalteinrichtung 10a den Umschalter 8a auf den Schwellenwert V2 um, wie in Fig. 4c dargestellt ist. Da der Schwellenwert V2 jedoch unter dem Schwellenwert V3 liegt, ändert das Ausgangssignal O1 nicht seinen Wert.

Wenn danach das Eingangssignal I zum Zeitpunkt t3 den Schwellenwert V'1 überschreitet, geht das Ausgangssignal O2 des Vergleichers 6b auf einen hohen Wert, wie in Fig. 4d dargestellt ist. Beim Überschreiten des Schwellenwertes V'2 gibt es wieder keine Signaländerung, während beim Überschreiten des Schwellenwertes V'3 zum Zeitpunkt t4 die Schalteinrichtung 10b den Umschalter 8b auf den Schwellenwert V'2 umschaltet. Das Ausgangssignal O2 des Vergleichers 6b ändert dadurch seinen Wert nicht.

Wenn das Eingangssignal I wieder abfällt, wird zum Zeitpunkt t5 der Schwellenwert V'2 durchlaufen, und damit geht das Ausgangssignal O2 wieder auf einen niedrigen Wert. Wenn zum Zeitpunkt t6 der Schwellenwert V'4 unterschritten wird, schaltet die Schalteinrichtung 10b den Umschalter 8b wieder auf den unteren Schwellenwert V'1 zurück. Da dieser Schwellenwert aber oberhalb des Eingangssignals beim Zeitpunkt t6 liegt, ändert sich das Ausgangssignal O2 nicht.

Zum Zeitpunkt t7 wird der Schwellenwert V2 unterschritten, und damit geht auch das Ausgangssignal O1 wieder auf einen niedrigen Wert. Schließlich wird zum Zeitpunkt t8 der Schwellenwert V4 unterschritten, und damit schaltet die Schalteinrichtung 10a den Umschalter 8a wieder auf den Schwellenwert V1. Damit ist der Anfangszustand wieder hergestellt.

Aus Fig. 4 ist zu erkennen, daß die Ausgangssignale O1 und O2 sowohl bei der ansteigenden Flanke als auch bei der abfallenden Flanke des Eingangssignals I zu einem relativ frühen Zeitpunkt den Wert wechseln. Der Schwellenwert V'4 ist hier nur beispielsweise gleich dem Schwellenwert V3 angenommen, tatsächlich können jedoch die Schwellenwerte V1 bis V4 beliebig gegenüber den Schwellenwerten V'1 bis V'4 verschoben sein, da sie voneinander unabhängig sind. Es ist auch leicht einzusehen, daß die Schaltung nach Fig. 3 durch zusätzliche Vergleicher und Schalteinrichtungen erweitert werden kann, wenn mehr als drei verschiedene Ausgangssignale erzeugt werden sollen. In der folgenden Beschreibung der weiteren Ausführungsbeispiele wird der Einfachheit halber davon ausgegangen, daß ein Ausgangssignal mit nur zwei verschiedenen Werten erzeugt werden soll.

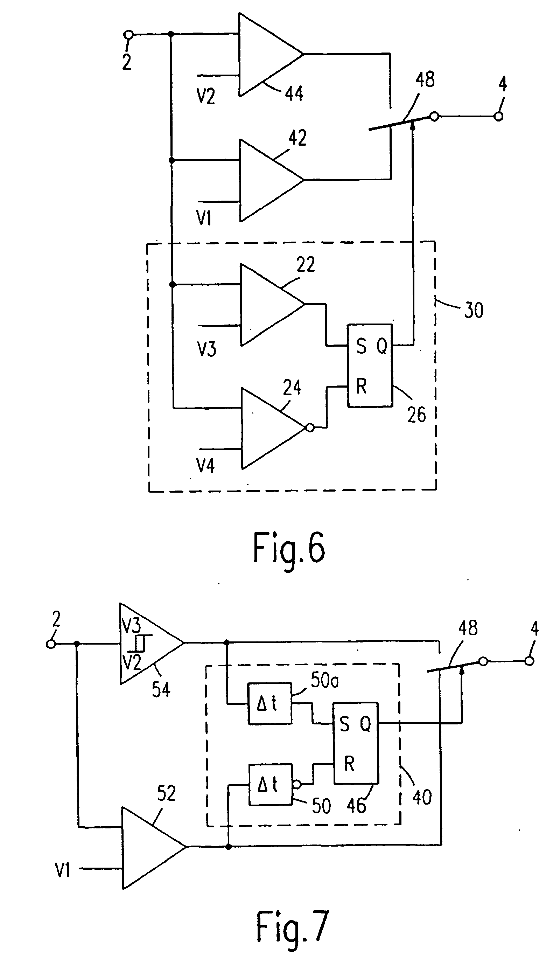

In Fig. 5 ist eine Schaltungsanordnung dargestellt, die ebenfalls einen Vergleicher 6 und einen Umschalter 8 aufweist, bei der jedoch die Schalteinrichtung 20 für den Umschalter 8 anders aufgebaut ist als bei der Schaltung nach Fig. 3. Die Schalteinrichtung 20 enthält zwei Vergleicher 22 und 24 mit je einem ersten Eingang, der mit dem Signaleingang 2 für das Eingangssignal I verbunden ist, und mit einem zweiten Eingang, der mit dem Schwellenwert V3 bzw. V4 verbunden ist. Der Vergleicher 22 erzeugt ein hohes Signal, wenn das Eingangssignal I den Schwellenwert V3 überschreitet, während der Vergleicher 24 ein hohes Signal nur erzeugt, wenn das Eingangssignal I unter dem Schwellenwert V4 liegt, wie durch den Kreis am Ausgang des Vergleichers 24 angedeutet ist. Die Schwellenwerte V1 bis V4 werden wie in Fig. 4 dargestellt angenommen.

Der Ausgang des Vergleichers 22 ist über ein Verzögerungsglied 32 mit einem Eingang S eines Flipflops 26 verbunden, während der Ausgang des Vergleichers 24 mit einem Eingang R dieses Flipflops über ein Verzögerungsglied 34 verbunden ist. Ein Ausgang Q des Flipflops 26 steuert den Umschalter 8.

Wenn zu Beginn das Eingangssignal I unter dem Schwellenwert V4 liegt, erhält das Flipflop 26 am Eingang R ein hohes Signal, so daß am Ausgang Q ein niedriges Signal abgegeben wird und der Umschalter 8 mit dem Schwellenwert V1 verbunden ist. Wenn das Eingangssignal I danach den Schwellenwert V4 überschreitet, wird das Signal am Eingang R des Flipflops 26 niedrig, jedoch bleibt dessen Zustand erhalten und der Ausgang Q niedrig und die Stellung des Umschalters 8 unverändert. Beim Überschreiten des Schwellenwertes V1 schaltet der Vergleicher 6 das Ausgangssignal 0 am Signalausgang 4 auf einen hohen Wert. Der Zustand des Flipflops 26 bleibt unverändert, bis das Eingangssignal I den Schwellenwert V3 überschreitet. In diesem Augenblick erhält, wenn zunächst der Einfluß des Verzögerungsglieds 32 nicht berücksichtigt wird, der Eingang S ein hohes Signal, und der Ausgang Q wird hoch und schaltet den Umschalter 8 auf den Schwellenwert V2, wodurch sich das Ausgangssignal 0 nicht ändert. Wenn danach das Eingangssignal I unter den Schwellenwert V3 fällt, wird das Signal am Eingang S des Flipflops 26 wieder niedrig, jedoch bleibt dessen Zustand erhalten, bis das Signal unter den Schwellenwert V4 fällt. Dann erzeugt der Vergleicher 24 wieder ein hohes Signal, und das Flipflop 26 schaltet um, wodurch der Ausgang Q ein niedriges Signal führt und den Umschalter 8 wieder auf den Schwellenwert V1 zurück schaltet. Beim Durchlaufen des Schwellenwertes 2 war das Ausgangssignal 0 wieder auf einen niedrigen Wert gegangen.

Aus dieser Beschreibung ist zu erkennen, daß sich die Schalteinrichtung 20 in genau gleicher Weise verhält wie die Schalteinrichtung 10a nach Fig. 3, wenn die Verzögerungsglieder 32 und 34 nicht berücksichtigt werden. Diese bewirken, daß das Flipflop 26 verzögert umgeschaltet wird, wobei dann die Eingangsspannung bereits einen höheren Wert als den Schwellenwert V3 bzw. einen niedrigeren Wert als den Schwellenwert V4 angenommen hat. Dadurch ist es möglich, die Schwellenspannung V3 nur wenig größer als die Schwellenspannung V2 oder sogar gleich dieser zu wählen. Entsprechend kann durch das Verzögerungsglied 34 die Schwellenspannung V4 nur wenig niedriger als die oder gleich der Schwellenspannung V1 gewählt werden. Wenn beide Verzögerungsglieder 32 und 34 verwendet werden, können sie auch durch ein einziges, gestrichelt dargestelltes Verzögerungsglied 36 am Ausgang des Flipflops 26 ersetzt werden.

Bei dem in Fig. 6 dargestellten Ausführungsbeispiel wird nicht die Schwellenspannung umgeschaltet, sondern es sind zwei Vergleicher 42 und 44 vorgesehen, die beide mit dem Signaleingang 2 verbunden sind und von denen der Vergleicher 42 das Eingangssignal mit der Schwellenspannung V1 und der Vergleicher 44 das Eingangssignal mit der Schwellenspannung V2 vergleicht. Der Signalausgang 4 ist hier mit einem Umschalter 48 verbunden, der den Signalausgang abhängig von der Schalterstellung mit dem Ausgang des Vergleichers 42 oder des Vergleichers 44 verbindet. Der Umschalter 48 wird von einer Schalteinrichtung 30 angesteuert, die grundsätzlich in gleicher Weise wie die Schalteinrichtung 20 nach Fig. 5 aufgebaut ist, lediglich die Verzögerungsglieder sind der Übersichtlichkeit halber weggelassen.

Die Funktion der Schaltung nach Fig. 6 ist wie folgt, wobei die Folge der Schwellenwerte wie in dem Diagramm nach Fig. 4 angegeben sein möge. Zunächst ist das Eingangssignal I niedriger als der Schwellenwert V4, so daß das Flipflop 26 in den rückgesetzten Zustand gebracht wird und das Signal am Ausgang Q niedrig ist und den Schalter in die gezeichnete untere Stellung bringt. Wenn das Eingangssignal I den Schwellenwert V1 überschreitet, wird das Signal am Ausgang des Vergleichers 42 und damit das Ausgangssignal O am Signalausgang 4 hoch. Wenn das Eingangssignal I danach den Schwellenwert V2 überschreitet, wird auch das Signal am Ausgang des Vergleichers 44 hoch, jedoch ist dieser Ausgang zunächst noch offen.

Beim Überschreiten des Schwellenwertes V3 wird das Flipflop 26 durch den Vergleicher 22 in der Schalteinrichtung 30 umgeschaltet, und damit geht der Umschalter 48 in die obere Stellung, wodurch sich das Ausgangssignal O jedoch nicht ändert.

Wenn danach das Eingangssignal I den Schwellenwert V2 unterschreitet, wird das Signal am Ausgang des Vergleichers 44 und damit das Ausgangssignal O am Signalausgang 4 niedrig. Das Signal am Ausgang des Vergleichers 42 ist jedoch noch zunächst hoch, und es wird erst niedrig, wenn das Eingangssignal I den Schwellenwert V1 unterschritten hat. Wenn danach auch der Schwellenwert V4 unterschritten wird, schaltet das Flipflop 26 wieder in den Anfangszustand zurück, so daß der Umschalter 48 wieder in die untere Stellung geschaltet wird. Das Ausgangssignal O ändert sich dabei nicht, sondern bleibt niedrig.

Aus dieser Beschreibung ist zu erkennen, daß die Schaltung nach Fig. 6 das gleiche Ausgangssignal erzeugt wie die Schaltung nach Fig. 5. Der Unterschied im Aufbau besteht darin, daß nun zwei Vergleicher 42 und 44 zusätzlich zu der Schalteinrichtung 30 verwendet werden und daß der Umschalter mit den Ausgängen dieser Vergleicher verbunden ist.

Aus den bisher beschriebenen Ausführungsbeispielen läßt sich eine wesentlich vereinfachte Schaltung ableiten, die in Fig. 7 dargestellt ist. Diese enthält einen Vergleicher 52, von dem ein Eingang mit dem Signaleingang 2 und ein weiterer Eingang mit dem Schwellenwert V1 verbunden ist. Ferner ist ein Schmitt-Trigger 54 vorhanden, der ebenfalls mit den Signaleingang 2 verbunden ist und der eine Hysterese zwischen den Schwellenwerten V2 und V3 aufweist. Der Ausgang des Vergleichers 52 und des Schmitt-Triggers 54 ist mit Eingängen eines Umschalters 48 verbunden, der abhängig von der Schalterstellung den Ausgang eines dieser beiden Elemente mit dem Signalausgang 4 verbindet. Der Ausgang des Vergleichers 52 ist außerdem über ein Verzögerungsglied 50, das hier auch eine durch den Kreis am Ausgang angedeutete invertierende Funktion hat, mit dem Eingang R eines Flipflops 46 verbunden, und der Ausgang des Schmitt-Triggers 54 ist außerdem mit dem Eingang S des Flipflops 46 gekoppelt, wobei in diesem Signalweg ebenfalls ein Zeitverzögerungsglied 50a liegen kann. Der Ausgang Q des Flipflops 46 steuert den Umschalter 48.

Bei der Schaltung nach Fig. 7 bildet lediglich das Flipflop 46 eine Schalteinrichtung 40, die die Stellung des Umschalters 48 steuert. Gegenüber den Schaltungen nach Fig. 5 und Fig. 6 sind die Vergleicher 22 und 24 weggelassen, da deren Funktion durch den Vergleicher 52 bzw. den Schmitt-Trigger 54 übernommen ist.

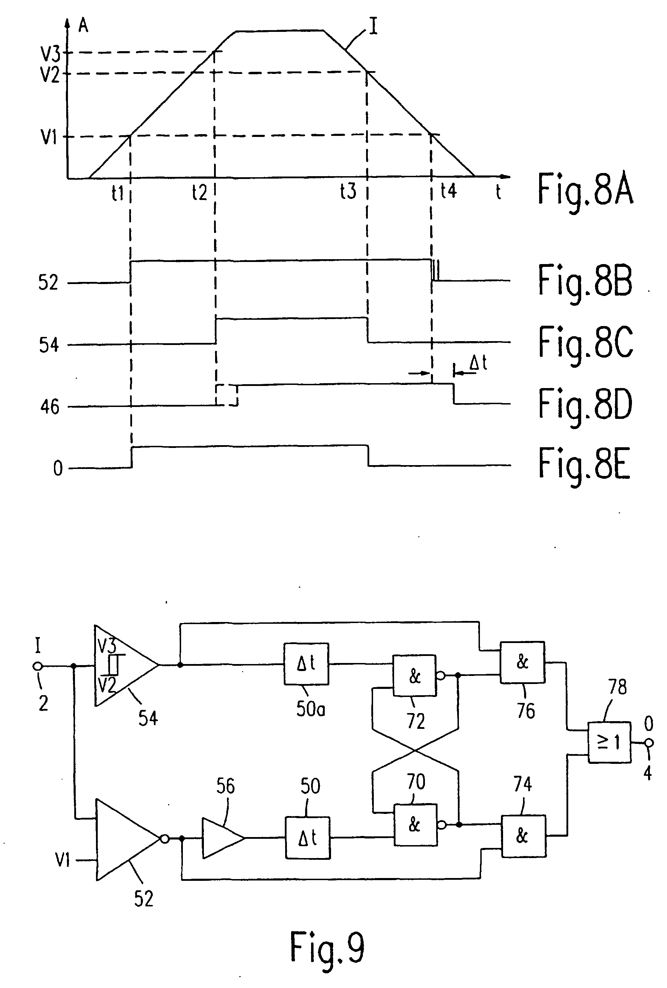

Die Funktion der Schaltung nach Fig. 7 soll anhand des in Fig. 8 dargestellten Diagramms erläutert werden. In Fig. 8a ist wieder der Verlauf des Eingangssignals I und die Lage der Schwellenwerte V1, V2 und V3 dargestellt. Der bei den vorher beschriebenen Schaltungen verwendete Schwellenwert V4 fällt mit dem Schwellenwert V1 zusammen und ist nicht gesondert angegeben. Zunächst ist das Signal am Ausgang des Vergleichers 52 und auch des Schmitt-Triggers 54 niedrig, so daß der Eingang R des Flipflops 46 ein hohes Signal erhält und das Flipflop 46 in die rückgesetzte Stellung bringt. Der Ausgang Q hat ein niedriges Signal, so daß der Umschalter 48 in der gezeichneten unteren Stellung steht.

Wenn das Eingangssignal I den Schwellenwert V1 zum Zeitpunkt t1 überschreitet, wechselt das Signal am Ausgang des Vergleichers 52 seinen Wert und wird hoch, und damit wird auch das Ausgangssignal O am Signalausgang 4 hoch, wie in Fig. 8b bzw. Fig. 8e dargestellt ist. Der Schmitt-Träger 54 gibt am Ausgang ein hohes Signal erst ab, wenn das Eingangssignal I den Schwellenwert V3 zum Zeitpunkt t2 überschritten hat, wie in Fig. 8c dargestellt ist. Damit wird das Flipflop 46 umgeschaltet, und zwar sofort, wenn das Verzögerungsglied 50 nicht vorhanden ist, bzw. entsprechend verzögert, wenn das Verzögerungsglied 50a vorhanden ist, wie in Fig. 8d dargestellt ist. Das Ausgangssignal O am Signalausgang 4 ändert dabei seinen Wert nicht, sondern bleibt hoch.

Wenn danach das Eingangssignal I wieder abfällt und den Schwellenwert V2 zum Zeitpunkt t3 unterschreitet, wird das Signal am Ausgang des Schmitt-Triggers 54 wieder niedrig und damit wird auch das Ausgangssignal O niedrig, da der Schalter 48 noch in der oberen Stellung steht. Wenn danach das Eingangssignal I zum Zeitpunkt t4 den Schwellenwert V1 unterschreitet, wird auch das Signal am Ausgang des Vergleichers 52 niedrig, und mit der Zeitverzögerung des Verzögerungsgliedes 50 wird das Flipflop 46 wieder zurückgeschaltet, und der Umschalter 48 geht wieder in die untere Stellung. Das Verzögerungsglied 50 verhindert die Auswirkung von kleinen Störungen im Eingangssignal I, denn wenn zum Zeitpunkt t4, wenn der Schwellenwert V1 gerade durchlaufen wird, kleine Störsignale auf dem Eingangssignal I vorhanden sind, der Schwellenwert V1 kurzzeitig mehrmals überschritten und unterschritten wird, und entsprechende Signale treten dann auch am Ausgang des Vergleichers 52 auf, wie in Fig. 8b angedeutet ist. Wenn das Verzögerungsglied 50 nicht vorhanden wäre, würde bei der ersten Flanke des Signals am Ausgang des Vergleichers 52 das Flipflop 46 umkippen und den Umschalter 48 auf diesen Ausgang umschalten, so daß die Signalwechsel am Ausgang des Vergleichers 52 auch am Signalausgang 4 erscheinen würden. Durch das Verzögerungsglied 50 wird das Flipflop 46 jedoch erst umgeschaltet, nachdem diese kurzen Signalwechsel am Ausgang des Vergleichers 52 abgeklungen sind.

Hieraus ist zu erkennen, daß das Verzögerungsglied 50 weggelassen werden kann, wenn der Vergleicher 52 ebenfalls als Schmitt-Träger mit einer Hysterese zwischen den Schwellenwerten V1 und V4 gemäß der in Fig. 4 dargestellten Folge der Schwellenwerte ersetzt wird. Andererseits kann auch der Schmitt-Träger 54 durch einen einfachen Vergleicher ersetzt werden, dessen zweiter Eingang den Schwellenwert V2 erhält, wenn das gestrichelt angedeutete Verzögerungsglied 50a vorhanden ist. Die Verzögerungsglieder 50 und 50a können jedoch auch vorgesehen werden, wenn der Vergleicher 52 als Schmitt-Trigger ausgeführt ist, um die Störsicherheit der Schaltungsanordnung bei beiden Flanken des Eingangssignals zusätzlich zu erhöhen.

In Fig. 9 ist eine Schaltungsanordnung dargestellt, die der Schaltungsanordnung nach Fig. 7 entspricht, wenn der Umschalter 48 und das Flipflop 46 durch einzelne Gatter realisiert werden. Der Ausgang des Vergleichers 52 ist mit einem Eingang eines UND-Gatters 74 sowie über einen Inverter 56 und ein Verzögerungsglied 50 mit einem Eingang eines NAND-Gatters 70 verbunden. Der Ausgang des Schmitt-Triggers 54 ist mit einem Eingang eines UND-Gatters 76 und über ein Verzögerungsglied 50a mit einem Eingang eines NAND-Gatters 72 verbunden. Die Ausgänge der NAND-Gatter 70 und 72 sind mit einem weiteren Eingang des jeweils anderen Gatters und mit einem weiteren Eingang des UND-Gatters 74 bzw. 76 verbunden. Die Ausgänge der UND-Gatrer 74 und 76 führen auf Eingänge eines ODER-Gatters 78, dessen Ausgang mit dem Signalausgang 4 verbunden ist. Die NAND-Gatter 70 und 72 bilden das Flipflop, während die Gatter 74, 76 und 78 den Umschalter realisieren. Die Funktion der Schaltung nach Fig. 9 ist die gleiche wie die nach Fig. 7, wie leicht zu erkennen ist.

## Patentansprüche

1. Schaltungsanordnung zum Erzeugen eines Ausgangssignals an einem Signalausgang mit mehreren vorgegebenen Werten, die im wesentlichen übergangslos wechseln, aus einem sich wesentlich langsamer ändernden, einem Signaleingang zugeführten Eingangssignal, wenn dieses Eingangssignal eines von mehreren Schwellenwerten durchläuft, unter Verwendung wenigstens eines Schwellwertschalters mit umschaltbaren Schwellenwerten der Schaltschwelle,
**dadurch gekennzeichnet,**
**daß** die Schaltschwelle bei einem niedrigen Eingangssignal einen ersten, niedrigen Schwellenwert hat, bei dessen Überschreiten durch das Eingangssignal das Ausgangssignal von einem ersten Wert auf einen zweiten Wert wechselt,
**daß** die Schaltschwelle auf einen zweiten, höheren Schwellenwert umgeschaltet wird, wenn das Eingangssignal einen dritten Schwellenwert überschreitet,
**daß** das Ausgangssignal wieder auf den ersten Wert wechselt, wenn das Eingangssignal den zweiten Schwellenwert unterschreitet, und
**daß** die Schaltschwelle auf den ersten Schwellenwert umgeschaltet wird, wenn das Eingangssignal einen vierten Schwellenwert unterschritten hat.

2. Schaltungsanordnung nach Anspruch 1, **dadurch gekennzeichnet, daß** der dritte Schwellenwert über dem zweiten Schwellenwert und/oder der vierte Schwellenwert unter dem ersten Schwellenwert liegt.

3. Schaltungsanordnung nach Anspruch 1, **dadurch gekennzeichnet, daß** der dritte Schwellenwert gleich dem zweiten Schwellenwerten ist und die Umschaltung der Schaltschwelle vom ersten auf den zweiten Schwellenwert verzögert erfolgt und/oder der vierte Schwellenwert gleich dem ersten Schwellenwert ist und die Umschaltung der Schaltschwelle vom zweiten auf den ersten Schwellenwert verzögert erfolgt.

4. Schaltungsanordnung nach einem der Ansprüche 1 bis 3, **dadurch gekennzeichnet, daß** wenigstens ein erster Vergleicher (6, 6a, 6b) mit einem ersten und einem zweiten Eingang sowie mit einem Ausgang vorgesehen ist, wobei der Ausgang mit dem Signalausgang (4) und der erste Eingang mit dem Signaleingang (2) gekoppelt ist und der zweite Eingang mit dem Ausgang eines ersten Umschalters (8, 8a, 8b) gekoppelt ist, der außerdem zwei Eingänge, denen der erste bzw. der zweite Schwellenwert (V1, V2, V'1, V'2) zugeführt ist, und einen Steuereingang aufweist, und daß für jeden Vergleicher (6, 6a, 6b) eine Schalteinrichtung (10a, 10b, 20) mit einem Eingang und einem Ausgang vorgesehen ist, wobei der Eingang mit dem Signaleingang (2) und der Ausgang mit dem Steuereingang des ersten Umschalters (8, 8a, 8b) gekoppelt ist und den ersten Umschalter vom ersten (V1, V'1) auf den zweiten Schwellenwert (V2, V'2) umschaltet, wenn das Eingangssignal (I) den dritten Schwellenwert (V3) überschreitet, und den ersten Umschalter vom zweiten (V2, V'2) auf den ersten Schwellenwert (V1, V'1) umschaltet, wenn das Eingangssignal (I) den vierten Schwellenwert (V4, V'4) unterschreitet.

5. Schaltungsanordnung nach einem der Ansprüche 1 bis 3, **dadurch gekennzeichnet, daß** wenigstens ein zweiter und ein dritter Vergleicher (42, 44, 52, 54) mit je wenigstens einem ersten Eingang und einem Ausgang vorgesehen ist, wobei der erste Eingang beider Vergleicher (42, 44, 52, 54) mit dem Signaleingang (2) verbunden ist und der zweite Vergleicher (42, 52) beim Durchlaufen des ersten Schwellenwertes (V1) und der dritte Vergleicher (44, 54) beim Durchlaufen des zweiten Schwellenwertes (V2) sein Signal am Ausgang wechselt und die Ausgänge beider Vergleicher mit Eingängen eines zweiten Umschalters (48) verbunden sind, von dem ein Ausgang mit dem Signalausgang (4) gekoppelt ist und der einen Steuereingang aufweist, und daß für je einen zweiten und dritten Vergleicher (42, 44, 52, 54) eine Schalteinrichtung (30, 40) mit einem Eingang und einem Ausgang vorgesehen ist, wobei der Eingang mit dem Signaleingang (2) und der Ausgang mit dem Steuereingang des zweiten Umschalters (48) gekoppelt ist und die Schalteinrichtung (30, 40) den zweiten Umschalter (48) vom Ausgang des zweiten (42, 52) auf den Ausgang des dritten Vergleichers (44, 54) umschaltet und diesen Ausgang mit dem Signalausgang (4) koppelt, wenn das Eingangssignal (I) den dritten Schwellenwert (V3) überschreitet, und den zweiten Umschalter (48) vom Ausgang des dritten (44, 54) auf den Ausgang des zweiten Vergleichers (42, 52) umschaltet und diesen Ausgang mit dem Signalausgang (4) koppelt, wenn das Eingangssignal den vierten Schwellenwert (V4) unterschreitet.

6. Schaltungsanordnung nach Anspruch 4 oder 5, **dadurch gekennzeichnet, daß** die Schalteinrichtung (10a, 10b) einen Schmitt-Trigger (12a, 12b) mit einem Eingang und einem Ausgang enthält, der eine Schalthysterese mit Umschaltspannungen entsprechend dem dritten (V3) und dem vierten Schwellenwert (V4) aufweist und dessen Eingang mit dem Signaleingang (2) und dessen Ausgang mit dem Steuereingang des Umschalters (8a, 8b) gekoppelt ist.

7. Schaltungsanordnung nach Anspruch 4 oder 5, **dadurch gekennzeichnet, daß** die Schalteinrichtung (20, 30) eine bistabile Speicherstufe (26) mit einem ersten und einem zweiten Eingang und einem Ausgang sowie einem ersten und einem zweiten weiteren Vergleicher (22, 24) enthält, die je einen ersten und einen zweiten Eingang und einen Ausgang aufweisen, wobei der Ausgang der Speicherstufe (26) mit dem Steuereingang des ersten bzw. zweiten Umschalters (8, 48) und die beiden Eingänge der Speicherstufe (26) je mit dem Ausgang der entsprechenden weiteren Vergleicher (22, 24) gekoppelt sind und wobei der erste Eingang beider weiterer Vergleicher (22, 24) mit dem Signaleingang (2) verbunden ist und dem zweiten Eingang beider weiterer Vergleicher (22, 24) der dritte (V3) bzw. der vierte Schwellenwert (V4) zugeführt ist.

8. Schaltungsanordnung nach Anspruch 5, **dadurch gekennzeichnet, daß** die Schalteinrichtung (40) eine bistabile Speicherstufe (46) mit einem ersten und einem zweiten Eingang und einem Ausgang enthält, wobei der Ausgang mit dem Steuereingang des zweiten Umschalters (48) gekoppelt ist und der erste Eingang mit dem Ausgang des zweiten Vergleichers (52) und der zweite Eingang mit dem Ausgang des dritten Vergleichers (54) gekoppelt ist.

9. Schaltungsanordnung nach Anspruch 8, **dadurch gekennzeichnet, daß** wenigstens einer der beiden Vergleicher (52, 54) als Schmitt-Trigger ausgebildet ist, der eine Schalthysterese mit Umschaltspannungen entsprechend dem ersten (V1) und dem vierten Schwellenwert (V4) für den zweiten Vergleicher (52) und entsprechend dem zweiten (V2) und dem dritten Schwellenwert (V3) für den dritten Vergleicher (54) hat.

10. Schaltungsanordnung nach einem der Ansprüche 7 bis 9, **dadurch gekennzeichnet, daß** wenigstens einem der Eingänge der bistabilen Speicherstufe (26, 46) eine Verzögerungsstufe (32, 34, 48, 48a) vorgeschaltet ist.

## Claims

1. A circuit arrangement for generating at its output an output signal, having a plurality of predetermined values which change over essentially without transition from an input signal which varies substantially more slowly and is applied to a signal input, when this input signal passes one of several threshold values, while at least one threshold value switch with switchable threshold values of the switching threshold is used,
**characterized in that**
for a low input signal, the switching threshold has a first, low threshold value at which the output signal changes over from a first value to a second value when the input signal exceeds said first threshold value,
that the switching threshold is switched to a second, higher threshold value when the input signal exceeds a third threshold value,
that the output signal changes back to the first value when the input signal drops below the second threshold value, and
that the switching threshold is switched over to the first threshold value when the input signal has dropped below a fourth threshold value.

2. A circuit arrangement as claimed in Claim 1, **characterized in that** the third threshold value is higher than the second threshold value and/or the fourth threshold value is lower than the first threshold value.

3. A circuit arrangement as claimed in Claim 1, **characterized in that** the third threshold value is equal to the second threshold value and that the switching over of the switching threshold from the first to the second threshold value takes place in a delayed fashion and/or the fourth threshold value is equal to the first threshold value and the switching over of the switching threshold from the second to the first threshold value takes place in a delayed fashion.

4. A circuit arrangement as claimed in one of the Claims 1 to 3, **characterized in that** there is provided
at least a first comparator (6, 6a, 6b) having a first and a second input as well as an output, the output being coupled to the signal output (4) and the first input is coupled to the signal input (2) and the second input is coupled to the output of a first switch (8, 8a, 8b) which also has two inputs which receive the first and the second threshold value (V1, V2, V'1, V'2) and also a control input, and that for each comparator (6, 6a, 6b) there is provided a switching device (10a, 10b, 20) having an input and an output, the input being coupled to the signal input (2) and the output to the control input of the first switch (8, 8a, 8b), the first switch being switched over from the first threshold value (V1, V'1) to the second threshold value (V2, V'2) when the input signal (I) exceeds the third threshold value (V3) whereas the first switch is switched over from the second threshold value (V2, V'2) to the first threshold value (V1, V'1) when the input signal (I) drops below the fourth threshold value (V4, V'4).

5. A circuit arrangement as claimed in one of the Claims 1 to 3, **characterized in that** at least a second and a third comparator (42, 44, 52, 54) are provided, having each at least a first input and an output, the first inputs of the two comparators (42, 44, 52, 54) being connected to the signal input (2), the signal at the output of the second comparator (42, 52) changing when the first threshold value (V1) is passed and the signal at the output of the third comparator (44, 54) changing when the second threshold value (V2) is passed, and the outputs of the two comparators being connected to inputs of a second switch (48) which has an output which is connected to the signal output (4) and has a control input, and that for each second and third comparator (42, 44, 52, 54) there is provided a respective switching device (30, 40) having an input and an output, the input being coupled to the signal input (2) and the output to the control input of the second switch (48), the switching device (30, 40) switching the second switch (48) from the output of the second comparator (42, 52) to the output of the third comparator (44, 54) and coupling this output to the signal output (4) when the input signal (I) exceeds the third threshold value (V3), and switching the second switch (48) from the output of the third comparator (44, 54) to the output of the second comparator (42, 52) and couples this output to the signal output (4) when the input signal drops below the fourth threshold value (V4).

6. A circuit arrangement as claimed in Claim 4 or 5, **characterized in that** the switching device (10a, 10b) includes a Schmitt trigger (12a, 12b) with an input and an output and a switching hysteresis with switching voltages corresponding to the third threshold value (V3) and the fourth threshold value (V4), its input being coupled to the signal input (2) and its output to the control input of the switch (8a, 8b).

7. A circuit arrangement as claimed in Claim 4 or 5, **characterized in that** the switching device (20, 30) includes a bistable storage stage (26), having a first and a second input and an output as well as a first and a second further comparator (22, 24), each of which having a first and a second input and an output, the output of the storage stage (26) being coupled to the control input of the first and the second switch (8, 48) respectively, the two inputs of the storage stage (26) being connected to the output of the respective corresponding further comparator (22, 24), the first input of the two further comparators (22, 24) being connected to the signal input (2) whereas the second input of the two further comparators (22, 24) receive the third threshold value (V3) and the fourth threshold value (V4), respectively.

8. A circuit arrangement as claimed in Claim 5, **characterized in that** the switching device (40) includes a bistable storage stage (46) with a first and a second input and an output, the output being connected to the control input of the second switch (48) whereas the first input is coupled to the output of the second comparator (52) and the second input to the output of the third comparator (54).

9. A circuit arrangement as claimed in Claim 8, **characterized in that** at least one of the two comparators (52, 54) is constructed as a Schmitt trigger with a switching hysteresis with switching voltages corresponding to the first threshold value (V1) and the fourth threshold value (V4) for the second comparator (52) and corresponding to the second threshold value (V2) and the third threshold value (V3) for the third comparator (54).

10. A circuit arrangement as claimed in one of the Claims 7 to 9, **characterized in that** at least one of the inputs of the bistable storage stage (26, 46) is preceded by a delay stage (32, 34, 50, 50a).

## Revendications

1. Circuit de production d'un signal de sortie à une sortie de signal avec plusieurs valeurs préalablement déterminées qui changent essentiellement sans transition à partir d'un signal d'entrée amené à une entrée de signal et varient essentiellement plus lentement lorsque ce signal d'entrée franchit une des plusieurs valeurs-seuils en utilisant au moins un commutateur de valeur-seuil avec des valeurs-seuils commutables du seuil de commutation,
**caractérisé en ce**
**que** le seuil de commutation en cas de signal d'entrée faible adopte une première valeur-seuil faible dont le dépassement par le signal d'entrée change le signal de sortie d'une première valeur à une deuxième valeur,
**que** le seuil de commutation est commuté à une deuxième valeur-seuil supérieure lorsque le signal d'entrée dépasse une troisième valeur-seuil,
**que** le signal de sortie passe de nouveau à la première valeur lorsque le signal d'entrée passe sous la deuxième valeur-seuil et
**que** le seuil de commutation est commuté sur la première valeur-seuil lorsque le signal d'entrée est passé sous une quatrième valeur-seuil.

2. Circuit selon la revendication 1, **caractérisé en ce que** la troisième valeur-seuil se trouve au-delà de la deuxième valeur-seuil et/ou la quatrième valeur-seuil en dessous de la première valeur-seuil.

3. Circuit selon la revendication 1, **caractérisé en ce que** la troisième valeur-seuil est égale à la deuxième valeur-seuil et que la commutation du seuil de commutation de la première à la deuxième valeur-seuil est retardée et/ou que la quatrième valeur-seuil est égale à la première valeur-seuil et la commutation du seuil de commutation de la deuxième à la première valeur-seuil est retardée.

4. Circuit selon l'une des revendications 1 à 3, **caractérisé en ce qu'**au moins un premier comparateur (6, 6a, 6b) est prévu avec des première et deuxième entrées ainsi qu'avec une sortie, la sortie étant couplée à la sortie du signal (4) et la première entrée à l'entrée du signal (2) et la deuxième entrée est couplée à la sortie d'un premier commutateur (8, 8a, 8b) qui présente par ailleurs deux entrées auxquelles sont amenées les première ou deuxième valeurs-seuils (V1, V2, V'1, V'2) et une entrée de commande et que, pour chaque comparateur (6, 6a, 6b), il est prévu un dispositif de commutation (10a, 10b, 20) avec une entrée et une sortie, l'entrée étant couplée à l'entrée de signal (2) et la sortie à l'entrée de commande du premier commutateur (8, 8a, 8b) et commute le premier commutateur de la première (V1, V'1) à la deuxième valeur-seuil (V2, V'2) lorsque le signal d'entrée (I) dépasse la troisième valeur-seuil (V3) et le premier commutateur de la deuxième (V2, V'2) à la première valeur-seuil (V1, V'1) lorsque le signal d'entrée (I) passe sous la quatrième valeur-seuil (V4, V'4).

5. Circuit selon l'une des revendications 1 à 3, **caractérisé en ce qu'**au moins un deuxième et un troisième comparateurs (42, 44, 52, 54) avec au moins une première entrée et une sortie sont prévus, la première entrée des deux comparateurs (42, 44, 52, 54) étant reliée avec l'entrée de signal (2) et le deuxième comparateur (42, 52) changeant son signal à la sortie en cas de franchissement de la première valeur-seuil (V1) et le troisième comparateur (44, 54) en cas de franchissement de la deuxième valeur-seuil (V2) et les sorties des deux comparateurs étant reliées aux entrées d'un deuxième commutateur (48) dont une sortie est couplée à la sortie de signal (4) et qui présente une entrée de commande et que, pour chaque deuxième et troisième comparateurs (42, 44, 52, 54), il est prévu un dispositif de commutation (30, 40) avec une entrée et une sortie, l'entrée étant couplée à l'entrée de signal (2) et la sortie à l'entrée de commande du deuxième commutateur (48) et le dispositif de commutation (30, 40) commute le deuxième commutateur (48) de la sortie du deuxième (42, 52) à la sortie du troisième comparateur (44, 54) et couplant cette sortie à la sortie du signal (4) lorsque le signal d'entrée (I) dépasse la troisième valeur-seuil (V3) et commute le deuxième commutateur (48) de la sortie du troisième (44, 54) à la sortie du deuxième comparateur (42, 52) et couplant cette sortie à la sortie de signal (4) lorsque le signal d'entrée passe sous la quatrième valeur-seuil (V4).

6. Circuit selon l'une des revendications 4 ou 5, **caractérisé en ce que** le dispositif de commutation (10a, 10b) contient une bascule de Schmitt (12a, 12b) avec une entrée et une sortie qui présente une hystérésis de commutation avec des tensions de commutation correspondant aux troisième (V3) et quatrième (V4) valeurs-seuils et dont l'entrée est couplée à l'entrée de signal (2) et dont la sortie est couplée à l'entrée de commande du commutateur (8a, 8b).

7. Circuit selon l'une des revendications 4 ou 5, **caractérisé en ce que** le dispositif de commutation (20, 30) présente un étage de mémoire bistable (26) avec des première et deuxième entrées et une sortie ainsi qu'un premier et un deuxième comparateurs supplémentaires (22, 24) qui présentent chacun une première et une deuxième entrées et une sortie, la sortie de l'étage de mémoire (26) étant reliée à l'entrée de commande des premier ou deuxième commutateurs (8, 48) et les deux entrées de l'étage de mémoire (26) étant respectivement couplées à la sortie du comparateur supplémentaire correspondant (22, 26) et la première entrée des deux comparateurs supplémentaires (22, 24) étant reliée à l'entrée de signal (2) et les troisième (V3) ou quatrième (V4) valeurs-seuils étant amenées à la deuxième entrée des deux autres comparateurs (22, 24).

8. Circuit selon la revendication 5, **caractérisé en ce que** le dispositif de commutation (40) contient un étage de mémoire bistable (46) avec des première et deuxième entrées et une sortie, la sortie étant couplée à l'entrée de commande du deuxième commutateur (48) et la première entrée à la sortie du deuxième comparateur (52) et la deuxième entrée à la sortie du troisième comparateur (54).

9. Circuit selon la revendication 8, **caractérisé en ce qu'**au moins l'un des deux comparateurs (52, 54) est conçu comme une bascule de Schmitt qui a une hystérésis de commutation avec des tensions de commutation correspondant aux première (V1) et quatrième (V4) valeurs-seuils pour le deuxième comparateur (52) et correspondant aux deuxième (V2) et troisième (V3) valeurs-seuils pour le troisième comparateur (54).

10. Circuit selon l'une des revendications 7 à 9, **caractérisé en ce qu'**un organe retardateur (32, 34, 48, 48a) est monté en amont d'au moins une des entrées de l'étage de mémoire bistable (26, 46).
